# EUROPEAN PATENT SPECIFICATION

(11) **EP 1 332 867 B1**
(45) Date of publication and mention of the grant of the patent: **07.06.2006**
(21) Application number: 01972689.2
(22) Date of filing: 04.10.2001
(51) Int. Cl.: B32B 15/08

(54) **FILM WITH MULTILAYERED METAL AND PROCESS FOR PRODUCING THE SAME**
FOLIE MIT MEHRSCHICHTIGEM METALL UND VERFAHREN ZUR HERSTELLUNG DERSELBEN
FILM DE METAL MULTICOUCHE ET SON PROCEDE DE FABRICATION

(30) Priority: 11.10.2000 JP 2000311038
(43) Date of publication of application: 06.08.2003
(73) Proprietor: Toyo Kohan Co., Ltd., Tokyo 102-8447 (JP)
(72) Inventor: SAIJO, Kinji TOYO KOHAN CO.,LTD. Technical Res.Lab, Kudamatsu-shi, Yamaguchi 744-8611 (JP); YOSHIDA,Kazuo, TOYO KOHAN CO.,LTD. Techn. Res.Lab., Kudamatsu-shi, Yamaguchi 744-8611 (JP); OKAMOTO, Hiroaki TOYO KOHAN CO.,LTD. Techn.Res.Lab, kudamatsu-shi, Yamaguchi 744-8611 (JP); OHSAWA,Shinji, TOYO KOHAN CO., LTD. Techn.Res.Lab., Kudamtsu-shi, Yamaguchi 744-8611 (JP)
(74) Representative: Vossius & Partner
(86) International application number: PCT/JP2001/008755
(87) International publication number: WO 2002/030665

(56) References cited:
- EP-A- 0 102 310
- EP-A- 0 249 744
- EP-A- 0 459 452
- EP-A- 0 496 334
- EP-A- 0 512 386
- EP-A2- 0 182 646
- WO-A-88/08043
- WO-A-97/11437
- DE-A- 2 632 549
- DE-A1- 2 754 248
- JP-A- 59 168 693
- US-A- 4 863 808
- US-A- 5 156 710
- US-A- 5 288 541
- US-A- 5 512 381
- PATENT ABSTRACTS OF JAPAN vol. 016, no. 208 (M-1249), 18 May 1992 (1992-05-18) & JP 04 033847 A (UBE IND LTD), 5 February 1992 (1992-02-05)
- PATENT ABSTRACTS OF JAPAN vol. 1995, no. 02, 31 March 1995 (1995-03-31) & JP 06 316759 A (TOMOEGAWA PAPER CO LTD), 15 November 1994 (1994-11-15)

## Description

The present invention relates a film with a multilayered metal which is obtained by laminating a polymer film with a metal foil by a method not using an adhesive, and a process for producing the same.

A large number of metal foil laminates in which a polymer film is laminated with a thin metal layer have been so far proposed.

For example, a laminate in which a thin metal layer is formed on a heat-resistant film typified by polyethylene terephthalate or polyimide is excellent in mechanical, electrical and thermal characteristics, and is used in a flexible circuit board or the like.

As a method in which a polymer film is laminated with a metal foil, there is a method in which a metal foil and a film are bonded using an adhesive as disclosed in JP-A-11-20786.

However, since an organic adhesive is poor in thermal characteristics as compared to a film and a metal, it has been problematic in heat resistance. As a method for improving it, a method in which a thin metal layer is directly formed on a film has been proposed as disclosed in Patent No. 2859330, JP-A-8-231717, JP-A-11-207866 and the like.

In this method, after forming a thin metal layer (from 10 to 1,000 nm) on a film by a thin layer forming method such as vacuum deposition or sputtering, the thickness has been further increased by a method such as electroplating when requiring the increase in thickness of the metal foil to obtain a metal laminate having a thickness of from 1 to 100 µm as disclosed in JP-A-8-231717.

However, the ordinary method in which the film is laminated with the metal foil has involved the problem that when a relatively thick metal foil is required, much time and cost are needed. Moreover, there has been an intricate problem that a vacuum process and a wet process have to be used in combination.

EP-A-0 512 386 discloses a method of improving the adhesion of a metal an organic material, in which a polyimide film is sputter-coated with Cr and Cu, and then electroplated with, Cu.

In US-A-4 863 808, a polyimide film is vacuum deposited with Cr and Cu, and then electrodeposited with Cu. In US-A-4 863 808 no metal foil is laminated to the polyimide film vacuum deposited with the metal.

EP-A-0 102 310 discloses a process for preparing a metal surface for adhesion to rubber in which a metal substrate is deposited with an ion beam splutter deposition metal to a metal substrate.

In DE-A-26 32 549, a polymer substrate is coated with a metal film by sputtering.

EP-A-0 459 452 discloses a method of fixing a metal foil on the surface of a polyimide layer with no adhesive. In EP-A-0 459 452, no metal layer is formed between the metal foil and the polyimide layer.

The first object of the invention is to provide a film with a multilayered metal which has a given thickness and is adhesive-free and which is obtained by bonding a polymer film having a thin metal layer previously formed on the surface by a thin film forming method such as vacuum deposition or sputtering to a metal foil having a given thickness without using an adhesive.

Further, the second object of the invention is to provide a process in which production of a film with a multilayered metal including formation of a thin layer on a polymer film and bonding to a metal foil is continuously performed.

The objects above can be achieved by the features specified in the claims.

The invention is described in detail in connection with the drawings, in which;
Fig. 1 is a sectional view of a film with a multilayered mental,
Fig. 2 is a sectional view of a film with a multilayered metal,
Fig. 3 is a schematic view showing a production process, and
Fig. 4 is a schematic view showing a production process.

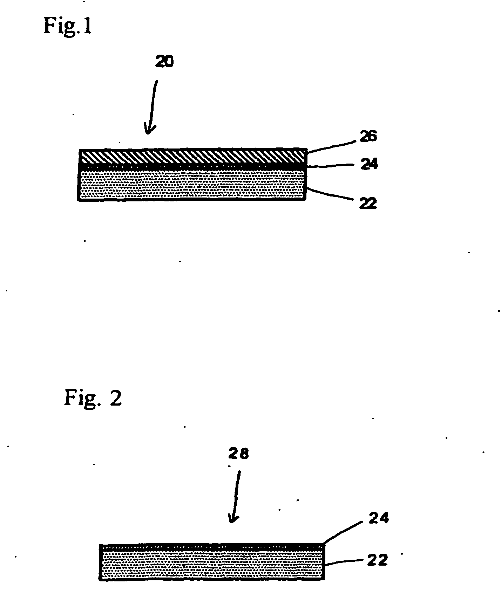

Fig. 1 is a schematic view showing a sectional structure of the film with the multilayered metal according to the invention.

In Fig. 1, a polymer film 22 is laminated on a metal foil 26 through a thin metal layer 24. With respect to a material of the polymer film 22, its type is not particularly limited so long as it is a material capable of forming a thin film on a film. It is selectively used, as required, according to the use of the film with the multilayered metal according to the invention.

For example, when the film with the multilayered metal according to the invention is used in a flexible printed board, polyimide, polyethylene terephthalate, polyether imide and the like are preferably used as the material of the polymer film.

Further, when the film with the multilayered metal according to the invention is applied to the use at high temperatures, a film such as a polyimide film can preferably be employed.

The thickness of the polymer film 22 varies with the use. When it is used in a flexible printed board, a range of from 10 to 150 µm is preferably used. A range of from 25 to 75 µm is more preferably uses.

With respect to a material of the thin metal layer 24, its type is not particularly limited so long as it is a material having a good adhesion to the polymer film as a base.

For example, when the polymer film 22 is a polyethylene terephtalate or polyimide film, Ni, Cr, Pd, Zr, Co, Au, Ag, Sn, Cu, Al and the like are preferably used as the thin metal layer 24. A thin metal layer comprising plural layers of these metals is also available. Further, an alloy of these metals is also available as the thin film.

The thickness varies with the use. When it is used in a flexible printed board, a range of from 0.01 to 1 µm is preferably used. A range of from 0.1 to 0.5 µm is more preferably used.

As a material of the metal foil 26, for example, a single-layer foil such as a copper foil, a nickel foil, an aluminum foil or an iron foil, a laminated foil (clad material) thereof, an alloy foil thereof, a rolled sheet thereof and the like can be used. Further, it is possible to use plated foils obtained by plating the surfaces thereof. The thickness varies with the use. When it is used in, for example, a flexible printed board, a range of from 3 to 100 µm is preferably used. A range of from 10 to 35 µm is more preferably used.

When the film with the multilayered metal according to the invention is used in a radiation plate, a range of from 50 to 1,000 µm by which it is somewhat thicker is preferably used for improving heat conduction.

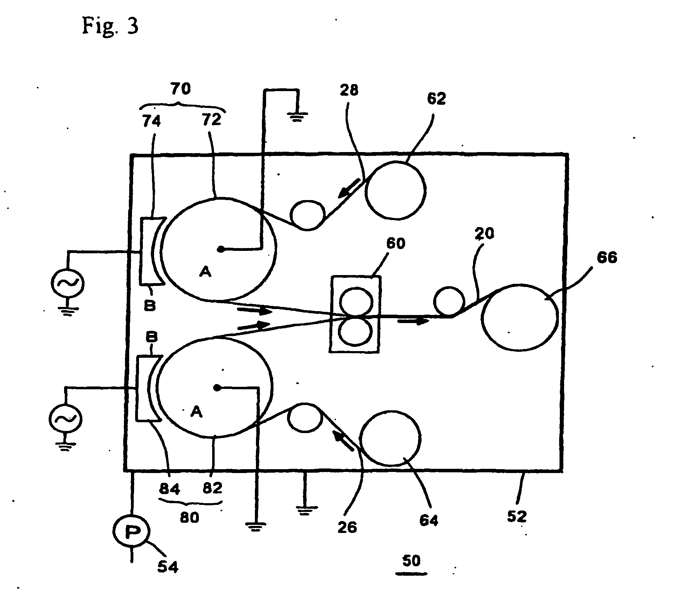

The process for producing the film with the multilayered metal according to the invention is described below. The first process is, as shown in Fig. 3, a process wherein a film having a this metal layer in which the thin metal layer has been formed on the polymer film is set on a unwinding reel 62 and the film 28 having the thin metal layer and a metal foil 26 are press-bonded by a press-bonding unit 60 in a vacuum container 52. That is, the film 28 having the thin metal layer in which the thin metal layer has been laminated on the surface of the polymer film 22 to a thickness of from 10 to 1,000 nm is activated with an activation device 70 mounted in an apparatus 50 for producing a film with a multilayered metal.

The activation here referred to indicates surface treatment for removing foreign matters adhered to the surface of the thin metal layer on the polymer film, such as metal oxides, dust-adhered matters and oil to improve adhesion to the metal foil in the subsequent step. Likewise; the metal foil 26 is also activated using an activation device 80.

With respect to the activation devices 70, 80, a devices having a mechanism capable of cleaning a surface can preferably be employed. In Examples of the invention, a device that conducts sputter-etching of respective bonding surfaces of materials to be press-bonded is employed.

That is, the method of activation by sputter-etching is performed, as previously disclosed by the present Applicant in JP-A-1-224184, by (4) conducting sputter-etching of the film 28 having the thin metal layer and the metal foil 26 (1) in an inert gas atmosphere under a very low pressure of from 1 x 10¹ to 1 x 10⁻² Pa such that (2) an alternating current with from 1 to 50 MHz is applied between one of electrodes A earthed respectively and another insulated and supported electrode B to allow glow discharge and (3) an area A of an electrode roll 72 or 82 exposed to plasma generated by the glow discharge is less than 1/3 of an area B of an electrode 74 or 84. This is preferable because the surface can be activated at high speed.

Moreover, the activation can also be performed using an ion gun or the like in which the surface activation is performed at high speed.

A method for press-bonding the film 28 having the thin metal layer to the metal foil 26 is described below. After the surface of the thin metal layer 24 formed on the polymer film and the bonding surface of the metal foil 26 are activated respectively in the apparatus 50 for producing the film with the multilayered metal, the activated clean bonding surfaces are superposed, and press-bonded and laminated with at press-bonding unit 60 disposed also within the apparatus 50 for producing the film with the multilayered metal. Since it is undesirable that the metal foil is broken or deformed by this press-bonding procedure, it is advisable that a draft in the press-bonding within the press-bonding unit 60 is from 0.1 to 3%.

The second method for producing the film with the multilayered metal according to the invention is described below.

In the second process, first of all, a thin layer forming unit 90 for forming the metal thin layer 24 on the polymer film 22 is mounted in the later step of the activation device 70 within the vacuum container 52.

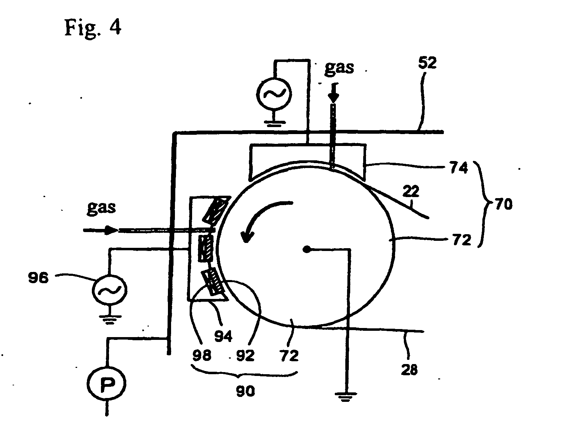

That is, as shown in Fig. 4, the bonding surface of the polymer film 22 is previously activated using the activation device 70. Subsequently, the thin metal layer 24 is immediately formed on the surface of the polymer film 22 within the same apparatus 50 for producing the film with the multilayered metal to give the film 28 having the thin metal layer as shown in Fig. 2.

Moreover, the metal foil 26 laminated laterally is also activated using the activation device 80 (Fig. 3), the surface on which the thin metal layer 24 has been formed in the film 28 having the thin metal layer and the activated surface of the metal foil 26 are superposed and press-bonded with the press-bonding unit 60, whereby the film 20 with the multilayered metal is produced in one process.

By the way, the thin film forming unit 90 may be mounted in the later step of the activation device 80 to form the thin metal layer on the surface of the metal foil 26. In this case, a structure of the polymer film, the thin metal layer, the thin metal layer and the metal foil is provided. Further, the thin metal layer can be multilayered by arranging plural thin film forming units.

As a method for forming the thin metal layer, known methods such as a sputtering method, an ion plating method and a vacuum deposition method (refer to JP-A-8-231717) can be used.

Moreover, when the surface of the polymer film 22 is roughened, the adhesion strength with the thin metal layer is preferably improves.

A sputter unit employed as an example of the thin film forming unit 90 used in the invention is described by referring to Fig. 4.

The sputter unit 90 comprises a combination of a target electrode 94 caused to electrically float and a water-cooled earthed electrode roll 72. A target 92 for forming the thin metal layer 24 is put on the target electrode 94, and a magnet 98 is also put thereon to improve the sputtering efficiency by a magnetic field.

Further, for preventing the target 92 from being abnormally heated, the target electrode 94 is adapted to be water-cooled.

In performing the sputtering, the pressure is maintained at 1 x 10⁻² Pa or less, and an inert gas such as argon, neon, xenon or krypton and a gas such as oxygen are then introduced into the vacuum container 52 to provide a gaseous atmosphere of from 1 x 10¹ to 1 x 10⁻² Pa.

Then, a high-frequency power source 96 is coupled with the target electrode 94 to generate plasma between the target electrode 94 and the electrode roll 72, whereby ion impact is applied to the target 92. Target atoms are thereby released to form the thin metal layer 24 on the polymer film 22.

### Examples

Examples are described below by referring to the drawing.

### (Example 1)

A polyimide film having a thickness of 50, µm was used as a polymer film. Further, a copper foil having a thickness of 35 µm was used as a metal foil.

### (1) Formation of a thin film on a polymer film

A thin nickel layer having a thickness of 300 nm as a thin metal layer 24 was formed on one surface of the polymer film 22 by a sputtering method. This surface was used as a bonding surface with the metal foil.

### (2) Lamination of a metal foil

The film 28 having the thin metal layer in which the thin nickel layer was formed on the surface of the polyimide film 22 and the copper foil 26 were set on unwinding reels 62, 64 respectively. A part of the film 28 having the thin metal layer which was unwound from the film-unwinding reel 62 and a part of the copper foil 26 were wound respectively on the water-cooled electrode rolls 72, 82 mounted within the vacuum container 52, and were sputter-etched in the first and second etching units 70, 80 for activation.

Subsequently, the film 28 having the thin metal layer and the copper foil 26 were sent to the press-bonding unit 60 where the bonding surfaces were superposed and subjected to cold-press-bonding with a low draft. The film 20 with the multilayered metal was taken up on a take-up roll 66.

### (Example 2)

A polyimide film having a thickness of 50 µm was used as a polymer film. Further, a copper foil having a thickness of 50 µm was used as a metal foil.

### (1) Activation

The polyimide film 22 and the copper foil 26 were set in the apparatus 50 for producing the film with the multilayered metal. The polyimide film 22 unwound from the film-unwinding reel 62 and the copper foil 26 unwound from the metal foil-unwinding reel 64 were wound respectively on the water-cooled electrode rolls 72, 82 within the vacuum container 52, and activated in the activation unit 70 by the sputter-etching method

### (2) Formation of a thin metal layer

After the polyimide film 22 was activated, it was sent to the sputter unit 90 while being wound on the water-cooled electrode roll 72 to form a thin nickel layer having a thickness of 200 nm as the thin metal layer 24.

### (3) Press-bonding

The bonding surfaces of the polymer film 22 with the thin metal layer 24 formed on the surface and the copper foil 26 were superposed, and subjected to cold-press-bonding with a draft of 0.5% to produce the film 20 with the multilayered metal.

Since the film with the multilayered metal according to the invention is a film obtained by press-bonding within the vacuum container without using an adhesive, the metal foil and the polymer film can be produced with a uniform thickness.

Further, since the surface activation, the formation of the thin metal layer and the press-bonding are performed in one process, the film with the multilayered metal can easily be obtained. Moreover, since the surface activation and the formation of the thin metal layer are conducted on the same electrode rolls, the apparatus can be rendered compact.

## Claims

1. A multilayered film comprising a polymer film (22), a metal layer (24) formed by a sputtering, ion plating or vacuum deposition method and a metal foil (26), wherein the metal foil (26) is laminated on the metal layer (24) formed on the polymer film (22).

2. A process for producing a multilayered film according to claim 1, which comprises
a step of setting a polymer film (22) having a metal layer (24) formed by a sputtering, ion plating or vacuum deposition method on a surface of the polymer film (22) on a film-unwinding reel (62),
a step of setting a metal foil (26) on a metal foil-unwinding reel (64),
a step of unwinding the polymer film (22) from the film-unwinding reel (62) and activating a surface of the metal layer (24),
a step of unwinding the metal foil (26) from the metal foil-unwinding reel (64) and activating a surface of the metal foil, and
a step of press-bonding the activated metal layer surface to the activated metal foil surface.

3. A process for producing a multilayered film according to claim 1, which comprises
a step of setting a polymer film (22) on a film-unwinding reel (62), a step of setting a metal foil (26) on a metal foil-unwinding reel (64),
a step of unwinding the polymer film (22) from the film-unwinding reel (62) and activating a surface of the polymer film (22) and forming a metal layer (24) by a sputtering, ion plating or vacuum deposition method on the surface of the polymer film (22), the metal layer having an activated surface,
a step of unwinding the metal foil (26) from the metal foil-unwinding reel (64) and activating a surface of the metal foil (26), and
a step of press-bonding the activated metal layer surface to the activated metal foil surface.

## Patentansprüche

1. Mehrschichtfilm mit einem Polymerfilm (22), einer durch ein Sputter-, Ionenplattierungs- oder Vakuumabscheidungsverfahren gebildeten Metallschicht (24) und einer Metallfolie (26), wobei die Metallfolie (26) auf die Metallschicht (24) laminiert ist, die auf dem Polymerfilm (22) gebildet ist.

2. Verfahren zur Herstellung eines Mehrschichtfilms nach Anspruch 1, das aufweist:
einen Schritt des Plazierens eines Polymerfilms (22) mit einer durch ein Sputter-, Ionenplattierungs- oder Vakuumabscheidungsverfahren auf einer Oberfläche des Polymerfilms (22) gebildeten Metallschicht (24) auf einer Filmabwickelspule (62),
einen Schritt des Plazierens einer Metallfolie (26) auf einer Metallfolienabwickelspule (64),
einen Schritt des Abwickelns des Polymerfilms (22) von der Filmabwickelspule (62) und Aktivierens einer Oberfläche der Metallschicht (24),
einen Schritt des Abwickelns der Metallfolie (26) von der Metallfolienabwickelspule (64) und Aktivierens einer Oberfläche der Metallfolie, und
einen Schritt des Preßverbindens der aktivierten Metallschichtoberfläche mit der aktivierten Metallfolienoberfläche.

3. Verfahren zur Herstellung eines Mehrschichtfilms nach Anspruch 1, das aufweist:
einen Schritt des Plazierens eines Polymerfilms (22) auf einer Filmabwickelspule (62), einen Schritt des Plazierens einer Metallfolie (26) auf einer Metallfolienabwickelspule (64),
einen Schritt des Abwickelns des Polymerfilms (22) von der Filmabwickelspule (62) und Aktivierens einer Oberfläche des Polymerfilms (22) sowie Bildens einer Metallschicht (24) durch ein Sputter-, Ionenplattierungs- oder Vakuumabscheidungsverfahren auf der Oberfläche des Polymerfilms (22), wobei die Metallschicht eine aktivierte Oberfläche hat,
einen Schritt des Abwickelns der Metallfolie (26) von der Metallfolienabwickelspule (64) und Aktivierens einer Oberfläche der Metallfolie (26), und
einen Schritt des Preßverbindens der aktivierten Metallschichtoberfläche mit der aktivierten Metallfolienoberfläche.

## Revendications

1. Film multicouche se composant d'un film polymère (22), d'une couche de métal (24) formée au moyen d'un procédé de pulvérisation, d'ionoplastie ou de dépôt sous vide et d'une feuille de métal (26), dans lequel la feuille de métal (26) est stratifiée sur la couche de métal (24) formée sur le film polymère (22).

2. Procédé de fabrication d'un film multicouche selon la revendication 1, qui comprend :
une étape d'ajustement d'un film polymère (22) comprenant une couche de métal (24) formée au moyen d'un procédé de pulvérisation, d'ionoplastie ou de dépôt sous vide sur une surface du film polymère (22) sur une bobine de dévidement de film (62) ;
une étape d'ajustement d'une feuille de métal (26) sur une bobine (64) de dévidement de feuille de métal;
une étape de déroulement du film polymère (22) à partir de la bobine de dévidement de film (62) et d'activation d'une surface de la couche de métal (24);
une étape de déroulement de la feuille de métal (26) à partir de la bobine (64) de dévidement de feuille de métal et d'activation d'une surface de la feuille de métal; et
une étape de liaison à la presse de la surface activée de la couche de métal et de la surface activée de la feuille de métal.

3. Procédé de fabrication d'un film multicouche selon la revendication 1, qui comprend:
une étape d'ajustement d'un film polymère (22) sur une bobine de dévidement de film (62) ;
une étape d'ajustement d'une feuille de métal (26) sur une bobine (64) de dévidement de feuille de métal;
une étape de déroulement du film polymère (22) à partir de la bobine de dévidement de film (62) et d'activation d'une surface du film polymère (22) et de formation d'une couche de métal (24) au moyen d'un procédé de pulvérisation, d'ionoplastie ou de dépôt sous vide sur la surface du film polymère (22), la couche de métal comprenant une surface activée;
une étape de déroulement de la feuille de métal (26) à partir de la bobine (64) de dévidement de feuille de métal et d'activation d'une surface de la feuille de métal (26) ; et
une étape de liaison à la presse de la surface activée de la couche de métal et de la surface activée de la feuille de métal.
